# EUROPEAN PATENT APPLICATION

(11) **EP 4 752 575 A1**
(43) Date of publication of application: **03.06.2026**
(21) Application number: 25217602.9
(22) Date of filing: 21.11.2025
(51) Int. Cl.: G01R 31/34

(54) **REMOVING SPURIOUS SIGNAL COMPONENTS IN A MEASURED MOTOR CURRENT SIGNAL FOR OPTIMIZED MOTOR DIAGNOSIS**

(30) Priority: 28.11.2024 LU 509107
(71) Applicant: Siemens Aktiengesellschaft, 80333 München (DE)
(72) Inventor: Decker, Thomas, 81739 München (DE); Ludwig, Christoph Ernst, 85748 Garching (DE); Malik, Vincent, 85748 Garching (DE); Rieskamp, Timo, 81739 München (DE)
(74) Representative: Siemens Patent Attorneys

(57) **Abstract**

Assistance apparatus and computer-implemented method for removing spurious signal components in a measured motor current signal of an electric motor (11) for optimized motor diagnosis, comprising the steps
- receiving (S1) the measured motor voltage signal (Um) and a measured motor current signal (Im) measured at the motor (11),
- generating (S2) a modelled current signal (Ims) by a motor model (15) depending on the measured motor voltage signal (Um),
- generating (S3) a reference current signal (Ips) by the motor model (15) depending on an undisturbed sinusoidal motor voltage signal (Up),
- adapting (S4) a noise removal module to infer optimal denoising parameters by inputting the modelled current signal (Ims) and the reference current signal (Ips) into the noise removal module (16),
- determining (S5) a denoised motor current signal (Id) by inputting the measured motor current signal (Im) into the adapted noise removal module, and
- outputting (S6) the denoised motor current signal (Id) for optimized motor diagnosis.

## Description

### Field of the Invention

The present disclosure relates to a computer-implemented method for removing spurious signal components in a measured motor current signal for optimized motor diagnosis, a system performing the method as well as a respective computer program product.

### Background

Electric motors play a crucial role in various industrial applications, such as pumps or conveyor belts. Consequently, a motor failure can have significant implications, causing important components of a production line or a waterworks system to malfunction. This, in turn, leads to substantial costs due to production stoppages. Considering the relatively low expenses associated with spare parts, such as bearings, or maintenance tasks, like motor realignment, there is a high demand for monitoring systems for these critical motors.

Different condition monitoring systems are known to monitor these vital production components. These systems utilize various motor signals to identify potential motor issues. One crucial signal is the motor current signature, which is recorded using sensors at the motor terminals. If the machinery sustains different types of damage, this signal typically exhibits suspicious patterns and anomalies in the data. Machine learning algorithms can then be trained to detect these anomalies and alert maintenance engineers in advance.

However, the motor current is heavily influenced by a supplied motor voltage signal. In real-world applications, this motor voltage signal has not a perfect sinusoidal waveform but is affected by various sources of interference, such as artifacts from other electrical devices connected to the same power grid. These devices introduce voltage components into the grid, which, in turn, affect the motor current signal. Consequently, important indications in the motor's output signal may be obscured.

Noise reduction techniques, such as lowpass or high-pass filtering, are commonly used to improve the signal-to-noise ratio of a motor's input voltage. However, these techniques do not consider motor-specific characteristics, which can lead to the removal of signal components that are not caused by grid disturbances but may still be important for subsequent motor current analysis, e.g. a motor current signature analysis (MCSA).

Additionally, these techniques may unintentionally eliminate signal components that are caused by mechanical issues in the motor, such as misalignment or unbalance. It is crucial not to discard these components from the current signal, as they need to be analyzed in the MCSA to detect such problems.

A method for mitigating spurious signals in the voltage input of an electronic motor is presented in US6199023. This method involves using an electronic model of the motor to estimate the signal components resulting from disturbances in the input voltage signal. The process involves transforming the motor voltage signal into the frequency domain, removing its fundamental components, and converting it back into the time domain. The resulting signal is then used as input for the electric motor model to calculate the corresponding motor current. Importantly, this motor current signal retains components originating from spurious signal elements in the input signal. In a final step, this calculated current signal is subtracted from the directly measured current signal at the motor terminals.

However, this approach has some trade-offs. While it prevents the use of a high-fidelity finite element model of the motor (due to the complete removal of the fundamental frequency from the voltage signal), relying on a low fidelity simplified electric model provides less accurate motor current values corresponding to disturbances in the motor voltage signal. Furthermore, the subtraction of signals assumes that the noisy signal can be linearly decomposed into a disturbance component and the actual motor signal, which is often not the case in reality and therefore does not lead to an optimal determination of the error component.

Therefore, it is an object of the present invention to reduce the signal components in the motor current that result from disturbances in the grid while preserving the signal components that indicate possible motor damage or misalignments.

### Brief Summary of the Invention

This object is solved by the features of the independent claims. The dependent claims contain further embodiment of the invention.

A first aspect concerns a computer-implemented method for removing spurious signal components in a measured motor current signal for optimized motor diagnosis, comprising the steps
- receiving the measured motor voltage signal and a measured motor current signal measured at the motor,
- generating a modelled current signal by a motor model depending on the measured motor voltage signal,
- generating a reference current signal by the motor model depending on a undisturbed sinusoidal motor voltage signal, characterized by
- adapting a noise removal module to infer optimal denoising parameters by inputting the modelled current signal and the reference current signal into the noise removal module,
- determining a denoised motor current signal by inputting the measured motor current signal into the adapted noise removal module, and
- outputting the denoised motor current signal for optimized motor diagnosis.

A second aspect concerns an assistance apparatus comprising at least one processor configured to perform the steps of removing spurious signal components in a measured motor current signal for an optimized motor diagnosis, comprising the steps
receiving the measured motor voltage signal and a measured motor current signal measured at the motor,
- generating a modelled current signal by a motor model depending on the measured motor voltage signal,
- generating a reference current signal by the motor model depending on a undisturbed sinusoidal motor voltage signal, characterized by
- adapting a noise removal module to infer optimal denoising parameters by inputting the modelled current signal and the reference current signal into the noise removal module,
- determining a denoised motor current signal by inputting the measured motor current signal into the adapted noise removal module, and
- outputting the denoised motor current signal for optimized motor diagnosis.

A third aspect of the invention concerns a computer program product directly loadable into an internal memory of at least one digital computer, comprising software code portions for performing the steps of the above-described method when said product is run on said at least one digital computer.

Advantageously, the described approach uses a motor model, which outputs motor currents very precisely for the considered electric motor. The precisely calculated output signals of the machine model enable an adapting the noise removal module to estimate an exact current noise signal and/or filter parameter. If this noise signal is not accurate enough, this could lead to a removal of important signal components of the measured motor current that contain information about possible motor issues such as misalignment and unbalance In comparison to more general techniques that do not use a motor model at all, the proposed method ensures that only signal component are removed which arises due to disturbances in the grid.

### Description of Embodiments

In an embodiment of the method the denoised motor current signal is input to a motor current analyser which outputs a motor diagnosis result.

Advantageously, the resulting motor diagnosis is based on the optimized denoised motor current resulting in a reliable and precise motor diagnosis result.

In an embodiment the sinusoidal motor voltage signal is generated having a frequency equal to a frequency of a supplied motor voltage signal.

Advantageously, based on this perfectly sinusoidal motor voltage signal the motor model generates a perfect undisturbed reference current signal of an ideal motor. Subsequently by correlating the modelled current signal with the undisturbed reference current signal results in an "undisturbed" noise signal, which can be considered for generating the denoised motor current signal.

In an embodiment the motor model is a deterministic simulation model, preferably a high-fidelity finite elements model, a high-fidelity digital twin, or a trained data-based model or a combination of both simulating the motor.

Such a motor model generates a reliable exact motor current signal.

In an embodiment the motor current analyser is a motor current signature analyser, MCSA, or a machine learning model, preferably a deep neural network, a self-organizing map or a decision tree trained to analyse the motor current signal.

MCSA is widely used in condition-based monitoring and predictive maintenance of electric motors in industrial applications, as it provides an effective way to continuously monitor motor health and plan maintenance accordingly. Using this is cost efficient and requires low adaption effort. Deep neural networks can be trained to analyze different types of motors and are thus very flexible.

In an embodiment a set of denoising parameters are determined depending on a differential signal between the generated modelled current signal and the generated reference current signal by the noise removal module.

This differential signal shows an improved noise immunity as a common mode noise affecting both signals is rejected as the receiver measures the difference between the two signals.

In an embodiment the set of denoising parameters are determined by inputting a disparity between the modelled current signal and the reference current signal into a timeseries data filter, optimizing the timeseries data filter to minimize the disparity.

Preferably, the timeseries data filter is structured as a linear autoregressive model, a wiener filter, a kernel adaptive filter or a recurrent neural network.

The denoising parameters are weights of the Al based filter model which are adapted continuously for the considered measured motor voltage resulting in a continuously optimized denoised motor current signal.

In an embodiment the measured motor current is input to the trained timeseries data filter outputting the denoised motor current signal.

Thus, the output denoised motor current signal is optimized with respect to the measured voltage signal and the measured current signal respectively.

In another embodiment the noise removal module comprises a noise cancelling unit that filters out unwanted signal components of the measured motor voltage signal depending on a reference noise signal.

Preferably, the reference noise signal is generated by inputting the modelled current signal and the reference current signal into a noise extractor unit and estimating the reference noise signal caused by voltage fluctuations only.

The noise signal is estimated by computing a difference between the simulated motor current and the reference current signal. This is a well-known and low processing capacity requiring calculation. Thus, the noise removal module can be implemented by a processor with low processing capacity.

This approach is most effective, if the reference noise signal is uncorrelated with the signal of interest, i.e., the measured current signal, but correlated with the noise to be reduced, i.e. that originates from perturbations in the input voltage signal.

In an embodiment, the estimated noise signal is refined by filtering out any frequency components which are commonly observed in measured motor signals, such as a fundamental supply frequency or winding harmonics.

Thus, the reference noise signal is further reduced to the fluctuations of interest.

### Brief description of the drawings

The invention will be explained in more detail by reference to accompanying figures. Similar objects will be marked by the same reference signs.
- Figure 1: schematically illustrates an embodiment of the inventive method as a flow chart.
- Figure 2: schematically illustrates an embodiment of the inventive assistance apparatus.
- Figure 3: schematically illustrates a detailed embodiment of the inventive assistance apparatus having a noise removal module with timeseries filter.
- Figure 4: schematically illustrates a detailed embodiment of the inventive assistance apparatus having a noise removal module with a noise cancelling function.
- Figure 5: schematically shows exemplary motor current signals as measured and denoised.

It is noted that in the following detailed description of embodiments, the accompanying drawings are only schematic, and the illustrated elements are not necessarily shown to scale. Rather, the drawings are intended to illustrate functions and the co-operation of components. Here, it is to be understood that any connection or coupling of functional units, modules, components or other physical or functional elements could also be implemented by a direct connection or an indirect connection coupling element, e.g., via one or more intermediate elements. A connection or a coupling of entities or components can for example be implemented by a wire-based, a wireless connection and/or a combination of a wire-based and a wireless connection. Functional modules can be implemented by dedicated hardware, e.g., processor, firmware or by software, and/or by a combination of dedicated hardware and firmware and software. It is further noted that each functional module described for an apparatus can perform a functional step of the related method and vice versa.

### Description of Examples

It is to be understood that the above description of examples is intended to be illustrative and that the illustrated components are susceptible to various modifications. For example, the illustrated concepts could be applied for different technical systems and especially for different sub-types of the respective technical system with only minor adaptions.

In an industrial environment, motor failure can have significant implications, causing important components of a production line or a waterworks system to malfunction. This, in turn, leads to substantial costs due to production stoppages. Considering the relatively low expenses associated for maintenance tasks, like motor realignment, there is a high demand for monitoring systems for these critical electric motors. One crucial signal is a motor current signature, which is recorded using sensors at the motor terminals. If the machinery sustains different types of damage, this signal typically exhibits suspicious patterns and anomalies in the data.

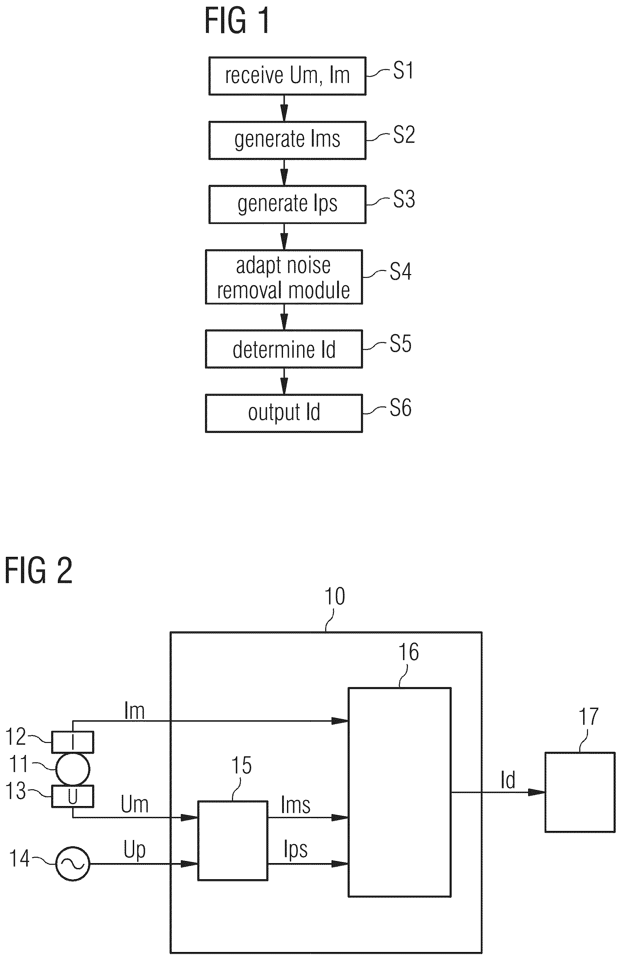

An embodiment of the proposed computer-implemented method for reducing signal components in a motor current signal that result from disturbances in a power grid while preserving the signal components that indicate possible motor damage or misalignments, is illustrated in Fig.1 and explained in the following.

The motor is an electric motor preferably deployed in an industrial environment such as a step motor in a production facility, as a drive applied in a conveyor system, in heavy machinery, in a vehicle and furthermore.

In a first step S1, a measured motor voltage signal Um and a corresponding measured motor current signal Im is received which are measured at the motor. The measured motor voltage signal and the measured current signal comprise data samples recorded via sensors located at respective motor terminals. A modelled current signal Ims is generated by a motor model depending on the measured motor voltage signal Um, see S2. Parallel to that, a reference current signal Ips is generated by the same motor model depending on an undisturbed sinusoidal motor voltage signal Up, see step S3. The undisturbed sinusoidal motor voltage signal Up is a perfectly sinusoidal signal, with a frequency equal to the supplied motor voltage frequency, e.g., 50 Hz or 60 Hz of a power supply network.

The modelled current signal Ims and the reference current signal Ips are input into a noise removal module. The noise removal module is adapted to infer optimal denoising parameters, see step S4. Different adaptation approaches are applicable, especially training a timeseries data filter resulting in optimized filter parameters, e.g., weights of a respective machine learning model or applying signal processing techniques for adaptive noise cancelling. A denoised motor current signal Id is determined by inputting the initially measured motor current signal Im into the adapted noise removal module, see S5. The resulting denoised motor current signal Id is output by the adapted noise removal module, see S6 to be used for an optimized motor diagnosis.

Preferably, the denoised motor current signal is input to a motor current analyser which outputs a motor diagnosis result which is optimized with respect to reliability and focussing on motor current components caused by motor specific issues instead of motor current components originating from fluctuations in the power supply grid. the motor current analyser is a motor current signature analyser, MCSA, or a machine learning model, preferably a deep neural network, a self-organizing map or a decision tree trained to analyse the motor current signal.

MCSA is a non-invasive technique that does not require direct access to the motor internals. It involves measuring the stator current of the motor and analyzing its frequency spectrum for any abnormal patterns or deviations. MCSA is widely used in condition-based monitoring and predictive maintenance of electric motors in industrial applications, as it provides an effective way to continuously monitor motor health and plan maintenance accordingly.

The applied motor model can be implemented by a deterministic simulation model, preferably a high-fidelity finite elements model or a high-fidelity digital twin. The applied motor model can be implemented by a trained data-based model or a combination of a deterministic simulation model and a data-driven model simulating the motor.

Electronic motor models are often used for circuit analysis, control system design, and predicting the overall electrical performance of the motor. Electronic modes typically refer to a circuit-based representations of the motor's electrical components and behavior. This type of model focuses on the electrical characteristics and performance of the motor, such as voltage, current, resistance, inductance, and torque output. The electronic model of an electric motor requires less processing capacity, but the output is often less precise.

In contrast, a finite element model of the electric motor is a more comprehensive, physics-based representation of the motor's structure and operation. The finite element model divides the motor into small, discrete elements and applies numerical analysis to simulate the complex physical interactions within the motor, including electromagnetic fields, structural mechanics and thermal effects. Thus, the finite element model provides a detailed, multi-physics simulation of the motor, allowing for more accurate predictions of performance, efficiency, and reliability compared to simpler electronic models.

Fig. 2 shows an inventive assistance apparatus 10 including the relevant objects which are source of data which are input and output to it. The measured motor voltage signal Um and the corresponding measured motor current signal Im are sampled by sensors 12, 13 located at a motor 11, e.g., at respective motor terminals. A voltage source 14 generating the reference current signal Up is preferably located separate from the motor 10 and the supply grid of the motor 10. In an embodiment, the voltage source 14 is located in the assistance apparatus. Also here, the output reference voltage signal Up shows a perfectly sinusoidal signal path, with a frequency equal to the motor voltage input frequency, e.g., 50 Hz.

The assistance apparatus 10 comprises a data input interface, not explicitly depicted, configured to receive the voltage and current signals. The assistance apparatus 10 comprises a motor model unit 15 comprising at least one processor configured to execute the motor model. Further, the assistance apparatus 10 comprises a noise removal unit 16 comprising at least one processor configured to perform the functions of the noise removal module.

The noise removal unit 16 receives the modelled current signal Ims and the reference current signal Ips from the motor model unit 15. Further, the noise removal unit 16 receives the measured motor current signal Im from the motor 10. The noise removal unit 16 is configured to perform the noise removal module. The noise removal unit 16 determines a set of denoising parameters depending on a differential signal between the generated modelled current signal Ims and the generated reference current signal Ips.

The assistance apparatus 10 comprises a data output interface, not explicitly depicted, which is configured to output the denoised motor signal Id received from the noise removal unit 16, to a motor current analyzer 17.

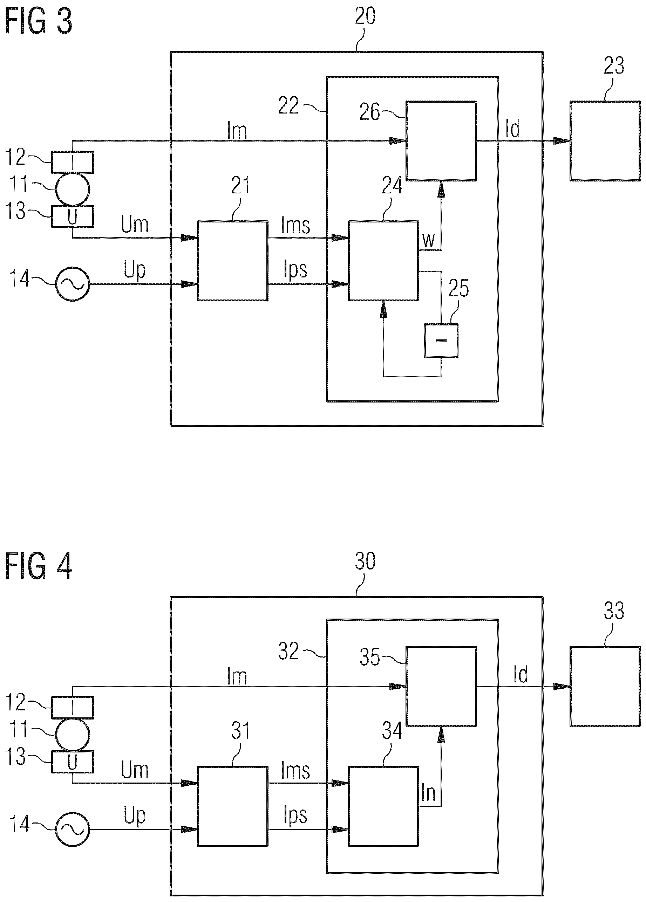

Fig.3 illustrates an assistance apparatus 30 having a noise removal unit 22 configured as a timeseries filter. The noise removal unit 22 comprises a timeseries filter to be trained 24 and a trained timeseries filter 26.

A disparity 25 between the modelled current signal Ims and the reference current signal Ips represents a disparity current that arises due to signal components other than the fundamental motor voltage frequency. The disparity 25 of the two current signals Ims, Ips refers to the difference or mismatch between two corresponding current waveforms or values in an electric motor system.

The timeseries filter 24, which is applied to the modelled current signal Ims, is trained with the disparity 25 as input with the goal to reduce the disparity 25 close to zero. The training of the timeseries filter results in denoising parameters w of the timeseries filter, which are weights of the underlying model. The trained timeseries filter 26 is configured with the denoising parameters w. In the final step, a trained timeseries filter 26 is applied to the measured current signal Im that is recorded at the motor terminal 11 to remove the noise components resulting in a denoised current signal Id. The denoised current signal Id can be for Motor Current Signature Analysis (MCSA) to detect motor issues. The timeseries data filter is structured as a linear autoregressive model, a wiener filter, a kernel adaptive filter or a recurrent neural network.

The motor model 21 is a model of the motor 10 in a "perfect" condition, meaning that no misalignment or imbalance is parameterized to ensure that signal components indicating a motor issue are not removed.

In contrast to existing solutions the described approach allows to use low-fidelity electric motor models as well as high-fidelity finite elements motor models to compute the motor currents.

High-fidelity finite elements motor models usually represent a much more accurate model of the motor. This is important since the motor model is used to estimate the exact disparity, i.e., the current noise signal. If this noise term is not accurate enough, this could lead to the removal of important signal components of the measured motor current Im that contain information about possible motor issues such as misalignment and unbalance. In comparison to more general techniques that do not use a motor model at all, this procedure ensures that only signal components are removed which arises due to disturbances in the grid.

Figure 4 schematically illustrates a detailed embodiment of the inventive assistance apparatus 30 having a noise removal unit 32 with a noise cancelling function.

The assistance apparatus 30 comprises a motor model unit 31 structured similar to the motor model unit 21 performing the motor model. The noise removal unit 32 of assistance apparatus 30 is configured to perform the functions of the noise removal module. The noise removal unit 32 contains two novel key characteristics.

First, a noise extractor unit 34 that infers optimal denoising parameters In and configurations based on the modelled current signal Ims and reference current signal Ips generated by the motor model in the motor model unit 31. Second, an adaptive noise cancelling unit 35 that performs signal denoising of the measured motor current signal Im based on reference noise signal In provided by the noise extractor unit 34. In this way, the quality of the measured motor current signal Im is enhanced which facilitates subsequent fault detection using either MCSA or suitable machine learning models located in a motor current analyzer 33.

The measured motor current signal Im is denoised using adaptive noise canceling, a signal processing technique that filters out unwanted signal components given an appropriate reference noise signal. An example adaptive noise canceling approach is described in B. Widrow et al., "Adaptive noise cancelling: Principles and applications," in Proceedings of the IEEE, vol. 63, no. 12, pp. 1692-1716, Dec. 1975, doi: 10.1109/PROC.1975.10036. It is assumed, that the reference noise signal In is expected to be uncorrelated with the signal of interest, i.e., an undisturbed motor current lo but correlated with the noise to be reduced that originates from perturbations on the measured input voltage Um.

To attain such a suitable reference noise signal In, the noise extractor unit 34 receives the modelled current signal Ims and the reference current signal Ips from the motor model unit 31 as input and estimates the noise caused purely by voltage fluctuations. The motor model unit 31 is configured to perform a motor model structured as a high-fidelity digital twin or low-fidelity model, a high-fidelity finite elements model, or a trained data-based model or a combination of both simulating the motor 11.

The reference noise signal In is determined by computing a difference between the modelled motor current signal Ims and the reference current signal Ips. Optionally, his difference, i.e., the reference noise signal In is further be refined by filtering out any frequency components which are commonly observed in real motor signals and hence should not be considered as noise due to the assumption of being uncorrelated to the signal of interest. Such commonly observed frequency components are, e.g., odd harmonics of the fundamental supply frequency mostly 50Hz, also referred to as winding harmonics.

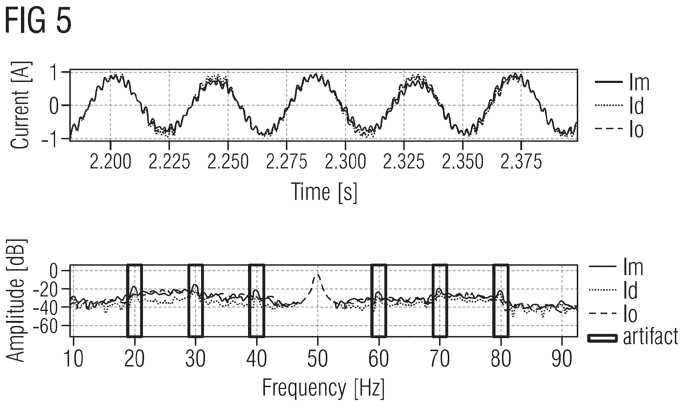

An exemplary result of the proposed method and assistance apparatus 30 is presented in the Fig. 5.

The measured motor current signal Im is depicted as solid line, where its time domain curve is presented in the top diagram which shows the current value versus time, and its frequency representation in the diagram below showing the altitude of the signal versus frequency. The frequency spectrum reveals suspicious peaks at round frequencies of 20, 30, 40, 60, 70, 80 Hz caused by voltage fluctuations triggered by other machines operating in the same power supply gird. These peaks are not present in a signal lo if the motor works in isolation, see signal depicted as dashed line. The enhanced version of this signal, i.e., the denoised signal Id obtained by the described method is shown as dotted line. It is able to mitigate the artifacts caused by voltage fluctuations as the corresponding peaks in the frequency spectrum vanish after filtering, see the marked sections in the lower diagram.

The presented approach allows denoising of signals that cannot be described as an additive signal component, resulting in significantly more accurate results. In the case of multiple similar motors connected to the same power supply network and exposed to the same disturbances, it is also possible to apply a filter trained on one motor to the remaining motors in order to clean the signal for subsequent motor current signature analysis (MCSA).

## Claims

1. Computer-implemented method for removing spurious signal components in a measured motor current signal of an electric motor (11) for optimized motor diagnosis, comprising the steps
- receiving (S1) the measured motor voltage signal (Um) and a measured motor current signal (Im) measured at the motor (11),
- generating (S2) a modelled current signal (Ims) by a motor model depending on the measured motor voltage signal (Um),
- generating (S3) a reference current signal (Ips) by the motor model depending on an undisturbed sinusoidal motor voltage signal (Up),
**characterized by**
- adapting (S4) a noise removal module to infer optimal denoising parameters by inputting the modelled current signal (Ims) and the reference current signal (Ips) into the noise removal module,
- determining (S5) a denoised motor current signal (Id) by inputting the measured motor current signal (Im) into the adapted noise removal module, and
- outputting (S6) the denoised motor current signal (Id) for optimized motor diagnosis.

2. Computer-implemented method according to claim 1, wherein inputting the denoised motor current signal (Id) to a motor current analyser (17) which outputs a motor diagnosis result.

3. Computer-implemented method according to any of the preceding claims, wherein the sinusoidal motor voltage signal (Up) is generated having a frequency equal to a frequency of a supplied motor voltage signal.

4. Computer-implemented method according to any of the preceding claims, wherein the motor model is a deterministic simulation model, preferably a high-fidelity finite elements model, a high-fidelity digital twin, or a trained data-based model or a combination of both simulating the motor (11).

5. Computer-implemented method according to claim 2, wherein the motor current analyser (17) is a motor current signature analyser, MCSA, or a machine learning model, preferably a deep neural network, a self-organizing map or a decision tree trained to analyse the motor current signal.

6. Computer-implemented method according to any of the preceding claims, wherein a set of denoising parameters (w, In) are determined depending on a differential signal between the generated modelled current signal (Ims) and the generated reference current signal (Ips) by the noise removal module.

7. Computer-implemented method according to claim 6, wherein the set of denoising parameters (w) are determined by inputting a disparity (25) between the modelled current signal (Ims) and the reference current signal (Ips) into a timeseries data filter (24), optimizing the timeseries data filter to minimize the disparity (25).

8. Computer-implemented method according to claim 7, wherein the measured motor current (Im) is input to the trained timeseries data filter (26) outputting the denoised motor current signal (Id).

9. Computer-implemented method according to any of claim 7-8, wherein the timeseries data filter (24, 26) is structured as a linear autoregressive model, a wiener filter, a kernel adaptive filter or a recurrent neural network.

10. Computer-implemented method according to any of claims 1-6, wherein the noise removal module comprises a noise cancelling unit (35) that filters out unwanted, spurious signal components of the measured motor current signal (Im) depending on a reference noise signal (In).

11. Computer-implemented method according to claim 10, wherein the reference noise signal (In) is generated by inputting the modelled current signal (Ims) and the reference current signal (Ips) into a noise extractor unit (34) and estimating the reference noise signal (In) caused by voltage fluctuations only.

12. Computer-implemented method according to claim 11, wherein the reference noise signal (In) is estimated by computing a difference between the simulated motor current (Ims) and the reference current signal (Ips).

13. Computer-implemented method according to claim 12, wherein the estimated reference noise signal (In) is refined by filtering out frequency components which are commonly observed in measured motor signals, such as a fundamental supply frequency or winding harmonics.

14. Assistance apparatus comprising at least one processor configured to perform the steps for an optimized motor diagnosis removing spurious signal components in a measured motor current signal of an electric motor (11) comprising the steps
- receiving the measured motor voltage signal (Um) and a measured motor current signal (Im) measured at the motor (11),
- generating a modelled current signal (Ims) by a motor model depending on the measured motor voltage signal (Um),
- generating a reference current signal (Ips) by the motor model depending on an undisturbed sinusoidal motor voltage signal (Up),
**characterized by**
- adapting a noise removal module to infer optimal denoising parameters by inputting the modelled current signal (Ims) and the reference current signal (Ips) into the noise removal module,
- determining a denoised motor current signal (Id) by inputting the measured motor current signal (Im) into the adapted noise removal module, and
- outputting the denoised motor current signal (Id) for optimized motor diagnosis.

15. A computer program product directly loadable into an internal memory of at least one digital computer, comprising software code portions for performing the steps of claim 1 when said product is run on said at least one digital computer.
